# EUROPÄISCHE PATENTSCHRIFT

(11) **EP 1 807 879 B1**
(45) Veröffentlichungstag und Bekanntmachung des Hinweises auf die Patenterteilung: **22.01.2020**
(21) Anmeldenummer: 05802534.7
(22) Anmeldetag: 27.09.2005
(51) Int. Cl.: H01L 33/08, H01L 33/20

(54) **Optoelektronischer Dünnfilmchip**
Optoelectronic thin-film chip
Puce optoélectronique à couche mince

(30) Priorität: 27.09.2004 DE 102004046792
(43) Veröffentlichungstag der Anmeldung: 18.07.2007
(73) Patentinhaber: OSRAM Opto Semiconductors GmbH, 93055 Regensburg (DE)
(72) Erfinder: STREUBEL, Klaus, 93164 Laaber (DE); WIRTH, Ralph, 93186 Pettendorf-Adlersberg (DE)
(74) Vertreter: Epping - Hermann - Fischer
(86) Internationale Anmeldenummer: PCT/DE2005/001711
(87) Internationale Veröffentlichungsnummer: WO 2006/034694

(56) Entgegenhaltungen:
- WO-A2-01/80322
- DE-A- 2 536 704
- US-A1- 2002 017 652
- "PREPARATION AND PROPERTIES OF MONOLITHICALLY INTEGRATED LENSES ON INGAASP/INP LIGHT-EMITTING DIODES" ELECTRONICS LETTERS, IEE STEVENAGE, GB, Bd. 18, Nr. 19, 1982, Seiten 831-832, XP000885201 ISSN: 0013-5194

## Beschreibung

Die Erfindung betrifft einen optoelektronischen Dünnfilmchip sowie ein Verfahren zur Herstellung eines optoelektronischen Dünnfilmchips.

Die Druckschrift I. Schnitzer at al., Appl. Phys. Lett. 63(16), 18. Oktober 1993, Seiten 2174 bis 2176 beschreibt das Grundprinzip eines Dünnfilmleuchtdiodenchips.

Die Druckschrift WO 02/13281 beschreibt einen Halbleiterchip mit einer Dünnfilmschicht. In der Dünnfilmschicht ist eine photonenemittierende aktive Zone ausgebildet. Auf einer von der Abstrahlrichtung des Dünnfilmchips abgewandten Oberfläche ist ein Träger angeordnet.

Die Präparation und die Eigenschaften von monolithisch integrierten Linsen in einer InGaAsP/InP-Leuchtdiode sind in der Druckschrift IEE Electronic Letters, Vol. 18, No. 19, Seiten 831 bis 832, aus dem Jahr 1982 beschrieben. Die Druckschrift WO 01/80322 A1 beschreibt einen optoelektronischen Dünnfilmchip mit einem strahlungsemittierenden Bereich in einer aktiven Zone einer Dünnfilmschicht mit darüber einer Linse.

Die Druckschrift DE 25 36 704 beschreibt eine lichtemittierende Diode mit einer konvexen Linse.

In der Druckschrift US 2002/0017652 A1 ist ein optoelektronischer Halbleiterchip angegeben.

Es ist Aufgabe der vorliegenden Erfindung einen Dünnfilmchip, gemäß Anspruch 1, mit verbesserten Lichtauskopplungseigenschaften anzugeben.

Weiter ist es Aufgabe der vorliegenden Erfindung ein Verfahren, gemäß Anspruch 11, zur Herstellung eines solchen Dünnfilmchips anzugeben.

Der Dünnfilmchip weist eine Dünnfilmschicht auf.

Die Dünnfilmschicht ist durch eine epitaktisch auf einem Aufwachssubstrat abgeschiedene Schichtenfolge gegeben, von der das Aufwachssubstrat zumindest teilweise entfernt ist. Das heißt, die Dicke des Substrats ist reduziert. Mit anderen Worten ist das Substrat gedünnt. Weiter ist es möglich, dass das gesamte Aufwachssubstrat von der der Dünnfilmschicht entfernt ist.

Die Dünnfilmschicht weist wenigstens eine aktive Zone auf, die zur Erzeugung elektromagnetischer Strahlung geeignet ist. Die aktive Zone kann beispielsweise durch eine Schicht oder Schichtenfolge gegeben sein, die einen pn-Übergang, eine Doppelheterostruktur, eine Einfachquantentopfstruktur oder eine Mehrfachquantentopfstruktur aufweist.

Die aktive Zone weist wenigstens einen strahlungsemittierenden Bereich auf. Der strahlungsemittierende Bereich ist dabei durch einen Teilbereich der aktiven Zone gebildet. In diesem Teilbereich der aktiven Zone wird im Betrieb des optoelektronischen Dünnfilmchips elektromagnetische Strahlung erzeugt.

Dem strahlungsemittierenden Bereich ist gemäß zumindest einer Ausführungsform des Dünnfilmchips eine Linse nachgeordnet. Unter Linse ist dabei beispielsweise ein optisches Element zu verstehen, das geeignet ist, elektromagnetische Strahlung, die durch das optische Element tritt, zu brechen. Es ist aber auch möglich, dass die Linse geeignet ist, elektromagnetische Strahlung zu beugen. Ferner ist es möglich, dass die Linse sowohl zur Lichtbrechung als auch zur Lichtbeugung geeignet ist. Bevorzugt ist die Linse dem strahlungsemittierenden Bereich derart nachgeordnet, dass zumindest ein Teil der im strahlungsemittierenden Bereich erzeugten elektromagnetischen Strahlung durch die Linse tritt und von dieser gebrochen und / oder gebeugt wird.

Die Linse ist durch zumindest einen Teilbereich der Dünnfilmschicht gebildet. Das heißt zumindest ein Teilbereich der Dünnfilmschicht ist derart strukturiert, dass er geeignet ist im strahlungsemittierenden Bereich erzeugte elektromagnetische Strahlung zu brechen und / oder zu beugen. Beispielsweise kann die Linse durch einen strukturierten Teilbereich einer Oberfläche des Dünnfilmchips gebildet sein. Bevorzugt weist dabei die Fläche des Dünnfilmchips die Linse auf, die ursprünglich dem Aufwachssubstrat zugewandt war. Der strukturierte Teilbereich der Dünnfilmschichtoberfläche kann beispielsweise eine definierte Krümmung aufweisen. Die Linse kann dann beispielsweise durch diesen Teil der Oberfläche begrenzt sein. Elektromagnetische Strahlung, die durch den gekrümmten Teilbereich der Oberfläche aus der Dünnfilmschicht tritt, wird dann zum Beispiel nach den Gesetzen der geometrischen Optik gebrochen.

Die laterale Ausdehnung der Linse ist größer als die laterale Ausdehnung des strahlungsemittierenden Bereichs. Unter lateraler Ausdehnung der Linse ist dabei beispielsweise die maximale Erstreckung der Linse in einer Ebene senkrecht zur Wachstumsrichtung der epitaktischen Schichtenfolge zu verstehen. Entsprechend bezeichnet die laterale Ausdehnung des strahlungsemittierenden Bereichs dann die maximale Erstreckung des strahlungsemittierenden Bereichs in einer Ebene senkrecht zur Wachstumsrichtung der epitaktischen Schichtenfolge.

Gemäß der erfindungsgemäßen Ausführungsform des optoelektronischen Dünnfilmchips wird also ein optoelektronischer Dünnfilmchip angegeben, der wenigstens einen strahlungsemittierenden Bereich in einer aktiven Zone einer Dünnfilmschicht aufweist. Dabei ist dem strahlungsemittierenden Bereich eine Linse nachgeordnet, die durch zumindest einen Teilbereich der Dünnfilmschicht gebildet ist und deren laterale Ausdehnung größer ist als die laterale Ausdehnung des strahlungsemittierenden Bereichs.

In wenigstens einer Ausführungsform des optoelektronischen Dünnfilmchips weist der optoelektronische Dünnfilmchip mehrere strahlungsemittierende Bereiche auf. Das heißt beispielsweise mehrere Teilbereiche der aktiven Zone der Dünnfilmschicht emittieren im Betrieb des optoelektronischen Dünnfilmchips elektromagnetische Strahlung. Die strahlungsemittierenden Bereiche können beispielsweise in einem regelmäßigen Muster mit im Wesentlichen gleichen Abständen zueinander in der aktiven Zone angeordnet sein. Bevorzugt sind in diesem Fall alle strahlungsemittierenden Bereiche im Wesentlichen gleich groß, das heißt alle strahlungsemittierenden Bereiche weisen beispielsweise im Wesentlichen die gleiche laterale Ausdehnung auf.

Im Wesentlichen gleiche laterale Ausdehnung bedeutet dabei, dass herstellungsbedingt oder aufgrund von ungewollten Inhomogenitäten in der Dünnfilmschicht Schwankungen in Ausdehnung und Anordnung der strahlungsemittierenden Bereiche möglich sind.

Ferner ist jedem strahlungsemittierenden Bereich bevorzugt genau eine Linse nachgeordnet. Das heißt jedem strahlungsemittierenden Bereich ist bevorzugt eine Linse eineindeutig zugeordnet. Der Anteil der von den strahlungsemittierenden Bereichen erzeugten elektromagnetischen Strahlung, der durch eine Linse tritt, ist dann größtenteils in dem der Linse zugeordneten strahlungsemittierenden Bereich erzeugt. Größtenteils in dem der Linse zugeordneten strahlungsemittierenden Bereich ist beispielsweise so zu verstehen, dass auch elektromagnetische Strahlung anderer, zum Beispiel benachbarter, strahlungsemittierender Bereiche durch diese Linse treten kann. Der größte Anteil elektromagnetischer Strahlung, der durch die Linse tritt, stammt aber aus dem ihr zugeordneten strahlungsemittierenden Bereich.

Bevorzugt weist ein Dünnfilmchip wenigstens achtzig strahlungsemittierende Bereiche auf. Entsprechend weist ein Dünnfilmchip bevorzugt wenigstens achtzig den strahlungsemittierenden Bereichen nachgeordnete Linsen auf.

Gemäß der erfindungsgemäßen Ausführungsform des optoelektronischen Dünnfilmchips weist der Dünnfilmchip einen Träger auf, auf den die Dünnfilmschicht aufgebracht ist. Bevorzugt ist der Träger dabei auf die vom ursprünglichen Aufwachssubstrat abgewandte Oberfläche der Dünnfilmschicht aufgebracht. Verglichen mit einem Aufwachssubstrat kann der Träger dabei relativ frei gewählt werden. So kann der Träger hinsichtlich mancher Eigenschaften wie etwa Leitfähigkeit oder Stabilität für das Bauteil besser geeignet sein, als verfügbare Aufwachssubstrate, die zur Herstellung hochwertiger epitaktisch gewachsener Schichtfolgen engen Einschränkungen unterliegen. So muss, um hochwertige epitaktische Schichten zu erhalten, das epitaktisch abgeschiedene Material beispielsweise Gitter-angepasst zum Aufwachssubstrat sein.

Bevorzugt zeichnet sich der auf die Dünnfilmschicht aufgebrachte Träger durch einen an die Dünnfilmschicht angepassten thermischen Ausdehnungskoeffizienten aus. Beispielsweise kann der Träger ein Halbleitermaterial wie Germanium, Galliumarsenid, Galliumnitrid, Siliziumcarbid und andere Materialien wie Saphir, Molybdän, Metalle oder Karbon enthalten.

Ferner zeichnet sich der Träger bevorzugt durch eine besonders gute thermische Leitfähigkeit aus, so dass durch die bei der Erzeugung von elektromagnetischer Strahlung in der aktiven Zone der Dünnfilmschicht entstehende Wärme zumindest teilweise über den Träger an die Umgebung abgegeben werden kann.

Gemäß zumindest einer Ausführung des Dünnfilmchips ist zwischen dem Träger und der Dünnfilmschicht eine Spiegelschicht angeordnet. Die Spiegelschicht kann beispielsweise einen Bragg-Spiegel oder eine metallhaltige Spiegelschicht umfassen. Ein metallhaltiger Spiegel, der beispielsweise Gold, Gold-Germanium, Silber, Aluminium oder Platin enthalten kann, zeichnet sich gegenüber einem Bragg-Spiegel beispielsweise durch eine geringere Richtungsabhängigkeit der Reflektivität aus. Auch lässt sich mit metallhaltigen Spiegeln eine höhere Reflektivität als mit Bragg-Spiegeln erreichen.

Besonders bevorzugt ist die zwischen Träger und Dünnfilmschicht angeordnete reflektierende Metallschicht geeignet, die vom strahlungsemittierenden Bereich erzeugte elektromagnetische Strahlung zu reflektieren, wodurch die Strahlungsausbeute des Dünnfilmchips erhöht wird.

Gemäß der erfindungsgemäßen Ausführungsform des optoelektronischen Dünnfilmchips weist der Dünnfilmchip wenigstens einen Stromeinkoppelbereich auf. Wobei der Stromeinkoppelbereich zwischen Träger und Dünnfilmschicht angeordnet ist. Mittels des Stromeinkoppelbereichs kann elektrischer Strom in die Dünnfilmschicht eingekoppelt werden, wo er in der aktiven Zone zur Erzeugung elektromagnetischer Strahlung genutzt wird. Beispielsweise kann der Stromeinkoppelbereich durch eine Kontaktfläche gebildet sein, über die die Dünnfilmschicht vom Träger her elektrisch kontaktiert werden kann.

Weist die Dünnfilmschicht beispielsweise in einer Ebene parallel zur Grenzfläche von Träger und Dünnfilmschicht eine besonders kleine elektrische Leitfähigkeit auf, das heißt, ist die Querleitfähigkeit der Dünnfilmschicht besonders klein, so gibt die laterale Ausdehnung des Stromeinkoppelbereichs im Wesentlichen die laterale Ausdehnung des strahlungsemittierenden Betreichs in der aktiven Zone der Dünnfilmschicht vor. Das heißt die laterale Ausdehnung des Stomeinkoppelbereichs entspricht im Wesentlichen der lateralen Ausdehnung des strahlungsemittierenden Bereichs. Im Wesentlichen bedeutet dabei, dass es aufgrund von zum Beispiel Schwankungen in der Querleitfähigkeit der Dünnfilmschicht zu Abweichungen kommen kann.

Die laterale Ausdehnung der Linse ist größer als die laterale Ausdehnung des Strahlungseinkoppelbereichs und damit größer als die laterale Ausdehnung des strahlungsemittierenden Bereichs.

Gemäß wenigstens einer Ausführungsform des optoelektronischen Dünnfilmchips, weist der Dünnfilmchip mehrere solche Stromeinkoppelbereiche auf. Bevorzugt ist jedem Stromeinkoppelbereich eineindeutig eine Linse zugeordnet. Stromeinkoppelbereich, strahlungsemittierender Bereich und Linse sind beispielsweise entlang einer Geraden, die senkrecht auf der Grenzfläche von Träger und Dünnfilmschicht steht, also im Wesentlichen parallel zur Wachstumsrichtung der Dünnfilmschicht verläuft, angeordnet.

Weiter ist es denkbar, dass die elektromagnetische Strahlung in den strahlungsemittierenden Bereichen beispielsweise durch optische und nicht durch elektrische Anregung erzeugt wird. Die Linse ist an der dem Träger abgewandten Oberfläche des Dünnfilmchips gebildet. Das heißt, die Linse ist bevorzugt durch die Strukturierung eines Teils dieser Oberfläche gebildet. Beispielsweise kann der Teil der Oberfläche dabei eine sphärische oder asphärische nach außen gewölbte Volumenlinse bilden. Es ist aber auch möglich, dass der strukturierte Teil der Dünnfilmschicht-Oberfläche eine Fresnel-Linse bildet.

Gemäß wenigstens einer Ausführungsform des optoelektronischen Dünnfilmchips beträgt die laterale Ausdehnung der Linse zwischen 30 und 100 µm. Unter lateraler Ausdehnung der Linse ist dabei beispielsweise der Durchmesser der Linse am Fußpunkt der Linse zu verstehen. Der Fußpunkt der Linse liegt dabei beispielsweise in der Ebene der Oberfläche des Dünnfilmchips in der die Linse gebildet ist.

Bevorzugt beträgt die laterale Ausdehnung der Linse zwischen 30 und 60 µm. Die Höhe der Linse, das heißt der Abstand vom Fußpunkt der Linse zum Scheitelpunkt der Linse beträgt beispielsweise zwischen 1 und 50 *µ*m, bevorzugt zwischen 1 und 20 *µ*m.

In zumindest einer Ausführung des Dünnfilmchips beträgt die laterale Ausdehnung des Stromeinkoppelbereichs zwischen 1 und 80 *µ*m, bevorzugt zwischen 10 und 40 *µ*m. Bei nur geringer Querleitfähigkeit der Dünnfilmschicht entspricht die laterale Ausdehnung des Stromeinkoppelbereichs im Wesentlichen der lateralen Ausdehnung des strahlungserzeugenden Bereichs.

Durch die Linse soll die Auskoppeleffizienz für die Auskoppelung elektromagnetischer Strahlung aus dem Dünnfilmchip optimiert werden, so beträgt der Abstand zwischen strahlungsemittierendem Bereich und Fußpunkt der Linse zwischen 1 und 25 *µ*m, besonders bevorzugt zwischen 1 und 10 *µ*m. Ist es etwa beabsichtigt, einen besonders großen Anteil der ausgekoppelten elektromagnetischen Strahlung in eine Richtung beispielsweise senkrecht zur Oberfläche der Dünnfilmschicht, auf der die Linse gebildet ist, zu konzentrieren, dann beträgt der Abstand zwischen strahlungsemittierenden Bereich und Fußpunkt der Linse bevorzugt zwischen 25 und 50 *µ*m, besonders bevorzugt zwischen 25 und 40 µm (nicht Teil dieser Erfindung). Die durch die Linse tretende Strahlung ist dann zumindest teilweise in einen Strahlkegel um diese Richtung konzentriert.

In der erfindungsgemäßen Ausführungsform des optoelektronischen Dünnfilmchips weist die Dünnfilmschicht an der Grenzfläche zwischen Dünnfilmschicht und Träger zumindest eine Vertiefung auf. Wobei die Vertiefung den Stromeinkoppelbereich zumindest teilweise umgibt. Besonders bevorzugt umgibt die Vertiefung den Stromeinkoppelbereich vollständig. Das heißt überstreicht man ausgehend von einem Stromeinkoppelbereich die Dünnfilmschicht an der Grenzfläche von Dünnfilmschicht und Träger so gelangt man bevorzugt in jeder Richtung, die in der Ebene dieser Grenzfläche liegt, zu der Vertiefung. Beispielsweise umgibt die Vertiefung genau einen Stromeinkoppelbereich. Bevorzugt ist jeder Stromeinkoppelbereich von wenigsten einer Vertiefung umgeben. Die Vertiefung kann dabei beispielsweise ringförmig um den Stromeinkoppelbereich angeordnet sein.

Gemäß zumindest einer Ausführungsform des Dünnfilmchips beträgt die Tiefe der Vertiefung zwischen 1 und 20 *µ*m. Das heißt die Vertiefung ist an ihrer tiefsten Stelle zwischen 1 und 20 *µ*m tief. Besonders bevorzugt ist die Vertiefung zwischen 1 und 8 *µ*m tief. Beispielsweise kann die Vertiefung vom Träger aus gesehen bis zum Beginn der aktiven Zone der Dünnfilmschicht reichen. Die Vertiefung durchtrennt die aktive Zone der Dünnfilmschicht dabei nicht.

Gemäß zumindest einer Ausführungsform des optoelektronischen Dünnfilmchips verjüngt sich die Vertiefung in Richtung der vom Träger abgewandten Oberfläche der Dünnfilmschicht. Beispielsweise weist die Vertiefung dabei ebene Innenwände auf. Die Innenwände der Vertiefung sind beispielsweise dem Stromeinkoppelbereich in Richtung vom Träger weg nachgeordnet. Bevorzugt schließen die Innenwände einen Winkel zwischen 10 und 90 Grad mit dem Träger ein. Besonders bevorzugt beträgt dieser Winkel zwischen 10 und 80 Grad.

Es wird weiter ein Verfahren zur Herstellung eines optoelektronischen Dünnfilmchips angegeben.

Gemäß der erfindungsgemäßen Ausführungsform des Verfahrens wird zunächst auf ein Aufwachssubstrat eine Dünnfilmschicht epitaktisch abgeschieden. Die Dünnfilmschicht ist beispielsweise eine epitaktisch gewachsene Schichtenfolge. Bevorzugt enthält die Dünnfilmschicht wenigstens eine Schicht oder Schichtenfolge, die als aktive Zone zur Erzeugung elektromagnetischer Strahlung geeignet ist.

Bevorzugt wird auf die dem Aufwachssubstrat abgewandte Oberfläche der Dünnfilmschicht eine dielektrische Schicht abgeschieden, in der im Folgenden wenigstens ein Stromeinkoppelbereich in Form einer Ausnehmung in der dielektrischen Schicht gebildet wird. Bevorzugt wird eine Vielzahl von Strahlungseinkoppelbereichen gebildet.

In einem folgenden Verfahrensschritt kann auf die dem Träger abgewandte Oberfläche der Dünnfilmschicht, zum Beispiel auf die dielektrische Schicht, beispielsweise eine Metallschicht aufgebracht werden, die geeignet ist, in der aktiven Zone erzeugte elektromagnetische Strahlung zu reflektieren.

Im Folgenden wird auf die dem Aufwachssubstrat abgewandten Oberfläche der Dünnfilmschicht ein Träger aufgebracht. Der Träger kann beispielsweise auf der Dünnfilmschicht mittels eines Lötverfahrens befestigt sein.

In einem weiteren Verfahrensschritt wird das Aufwachssubstrat dann von der Dünnfilmschicht entfernt.

Gemäß der erfindungsgemäßen Ausführungsform des Verfahrens wird auf der dem Träger abgewandten Oberfläche der Dünnfilmschicht wenigstens eine Linse hergestellt. Bevorzugt ist die Linse einem Stromeinkoppelbereich nachgeordnet. Besonders bevorzugt wird bei mehreren Stromeinkoppelbereichen jedem Stromeinkoppelbereich genau eine Linse nachgeordnet.

Gemäß zumindest einer Ausführungsform des Verfahrens zur Herstellung eines optoelektronischen Dünnfilmchips wird die Linse mittels wenigstens eines Ätzprozesses hergestellt. Auf diese Weise können auf der dem Träger abgewandten Oberfläche der Dünnfilmschicht beispielsweise sphärische, asphärische oder Fresnel-Linse hergestellt werden.

Im Folgenden wird der hier beschriebene optoelektronische Dünnfilmchip anhand von Ausführungsbeispielen und den dazu gehörigen Figuren näher erläutert.
Figur 1 zeigt eine schematische Schnittdarstellung eines ersten nicht erfindungsgemäßen Ausführungsbeispiels des Dünnfilmchips.
Figur 2 zeigt eine schematische Schnittdarstellung eines zweiten nicht erfindungsgemäßen Ausführungsbeispiels des Dünnfilmchips.
Figur 3 zeigt eine schematische Schnittdarstellung eines dritten Ausführungsbeispiels des Dünnfilmchips.
Figur 4 zeigt eine schematische Schnittdarstellung eines vierten Ausführungsbeispiels des Dünnfilmchips.
Figur 5a zeigt eine Tabelle mit berechneten Werten des Auskoppelwirkungsgrads des Dünnfilmchips für verschiedene Werte der Linsendicke für ein Ausführungsbeispiel des Dünnfilmchips.
Figur 5b zeigt eine graphische Auftragung des Auskoppelwirkungsgrads gegen die Linsendicke für ein Ausführungsbeispiel des Dünnfilmchips.
Figur 6a zeigt eine Tabelle mit berechneten Werten des Auskoppelwirkungsgrads in Abhängigkeit des Abstands zwischen strahlungsemittierendem Bereich und dem Fußpunkt der Linse für ein Ausführungsbeispiel des Dünnfilmchips.
Figur 6b zeigt eine graphische Auftragung des Auskoppelwirkungsgrads gegen den Abstand zwischen strahlungsemittierendem Bereich und Fußpunkt der Linse für ein Ausführungsbeispiel des Dünnfilmchips.

In den Ausführungsbeispielen und Figuren sind gleiche oder gleich wirkende Bestandteile jeweils mit den gleichen Bezugszeichen versehen. Die dargestellten Elemente der Figuren sind nicht als maßstabsgerecht anzusehen. Vielmehr können einzelne Elemente der Figuren zum besseren Verständnis teilweise übertrieben groß und nicht in tatsächlicher Größenrelation zueinander dargestellt sein.

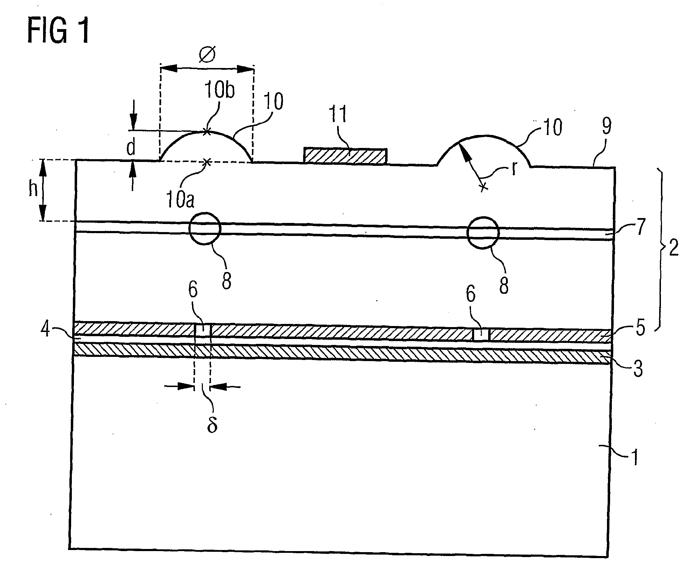

Figur 1 zeigt eine schematische Schnittdarstellung eines ersten nicht erfindungsgemäßen Ausführungsbeispiels des hier beschriebenen optoelektronischen Dünnfilmchips.

In diesem Ausführungsbeispiel ist auf dem Träger 1 eine Dünnfilmschicht 2 angeordnet.
Der Träger 1 ist beispielsweise durch einen Wafer gegeben. Beispielsweise kann der Träger wenigstens eines der folgenden Materialien enthalten: Germanium, Galliumarsenid, Galliumnitrid, Siliziumkarbid, Saphir, Molybdän, Metalle, Karbon.

Es ist aber auch möglich, dass der Träger 1 durch eine flexible, elektrisch leitende Folie gebildet ist. Beispielsweise kann der Träger durch eine Karbonfolie gegeben sein. Die Dicke der Folie ist dabei bevorzugt kleiner gleich 100 *µ*m.

Der Träger ist beispielsweise mittels einer Lotschicht 3 mit der Dünnfilmschicht 2 verbunden. Auf die dem Träger zugewandte Grenzfläche der Dünnfilmschicht 2 ist beispielsweise eine elektrisch isolierende dielektrische Schicht 5 aufgebracht.

Der dielektrischen Schicht 5 folgt eine reflektierende Metallschicht 4 nach, die beispielsweise ein reflektierendes Metall wie Gold, Silber, Goldgermanium, Aluminium oder Platin enthält.

Die reflektierende Metallschicht 4 ist zum einen bevorzugt besonders gut elektrisch leitend und zum anderen geeignet die in den strahlungsemittierenden Bereichen 8 der Dünnfilmschicht 2 erzeugte elektromagnetische Strahlung zumindest teilweise in Richtung der Oberfläche 9 der Dünnfilmschicht 2 zu reflektieren. Die Oberfläche 9 ist die dem Träger 1 abgewandte Oberfläche, die ursprünglich dem entfernten Aufwachssubstrat zugewandt war.

Die dielektrische Schicht 5 weist Durchbrüche auf, welche die Stromeinkoppelbereiche 6 bilden. Die Durchbrüche enthalten dabei beispielsweise das Material der reflektierenden Metallschicht 5. Die Stromeinkoppelbereiche 6 weisen beispielsweise eine laterale Ausdehnung *δ* auf. Sie können beispielsweise zylinderförmig ausgebildet sein. Die laterale Ausdehnung *δ* ist dann durch den Durchmesser dieses Zylinders gegeben.

Die Dünnfilmschicht 2 basiert beispielsweise auf Phosphid-Verbindungshalbleitermaterialien oder auf Nitrid-Verbindungshalbleitermaterialien.

"Auf Phosphid-Verbindungshalbleitern basierend" bedeutet in diesem Zusammenhang, dass ein derart bezeichnetes Bauelement oder Teil eines Bauelements vorzugsweise AlₙGaₘIn₁₋ₙ₋ₘP umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, P), auch wenn diese teilweise durch geringe Mengen weiterer Stoffe ersetzt sein können.

Auf Nitrid-Verbindungshalbleitern basierend" bedeutet im vorliegenden Zusammenhang, dass die aktive Epitaxie-Schichtenfolge oder zumindest eine Schicht davon ein Nitrid-III/V-Verbindungshalbleitermaterial, vorzugsweise AlₙGaₘIn₁₋ₙ₋ₘN umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die charakteristischen physikalischen Eigenschaften des AlₙGaₘIn₁₋ₙ₋ₘN-Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

Dies ist dabei so zu verstehen, dass die Dünnfilmschicht wenigstens eine Einzelschicht enthält, die ein Material aus den jeweiligen Verbindungshalbleitermaterialsystemen enthält.

Die Dünnfilmschicht 2 weist weiter bevorzugt wenigstens eine aktive Zone 7 auf, die zur Erzeugung elektromagnetischer Strahlung geeignet ist. Die aktive Zone 7 kann beispielsweise einen pn-Übergang, eine Doppelheterostruktur, eine Einfachquantentopfstruktur oder eine Mehrfachquantentopfstruktur aufweisen.

Die Bezeichnung Quantentopfstruktur umfasst im Rahmen der Anmeldung jegliche Struktur, bei der Ladungsträger durch Einschluss ("Confinement") eine Quantisierung ihrer Energiezustände erfahren. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen.

Wird Strom durch die Stromeinkoppelbereiche 6 in die Dünnfilmschicht 2 eingekoppelt, so fließt wegen der geringen Querleitfähigkeit der für die Dünnfilmschicht 2 verwendeten Materialien Strom im Wesentlichen senkrecht zum Träger 1 zur aktiven Zone 7. Dort wo die aktive Zone 7 bestromt wird entstehen strahlungsemittierende Bereiche 8. Die laterale Ausdehnung der strahlungsemittierenden Bereiche 8 ist dabei wegen der geringen Querleitfähigkeit des Materials der Dünnfilmschicht 2 im Wesentlichen durch die laterale Ausdehnung der Stromeinkoppelbereiche 6 gegeben.

Jedem strahlungsemittierenden Bereich 8 ist in einem Abstand h zwischen aktiver Zone 7 und Oberfläche 9 eine Linse 10 nachgeordnet. Die Linse 10 ist beispielsweise eine Volumenlinse. Sie kann beispielsweise sphärisch oder asphärisch nach außen gewölbt sein. Die Linse ist durch ihre Dicke d charakterisiert, die den Abstand zwischen Fußpunkt 10a der Linse und Scheitelpunkt 10b der Linse angibt. Handelt es sich beispielsweise um eine sphärische Linse 10, so ist die Krümmung der Linse 10 durch den Linsenradius r bestimmt. Weiter ist die Linse durch ihre laterale Ausdehnung Φ am Fußpunkt 10a der Linse 10 charakterisiert. Der Fußpunkt 10a der Linse 10 liegt dabei beispielsweise in der Ebene der Oberfläche 9 der Dünnfilmschicht 2. Das heißt der Abstand h beschreibt den Abstand zwischen strahlungsemittierenden Bereich 8 und Fußpunkt 10a der dem strahlungsemittierenden Bereich 8 nachgeordneten Linse. Elektromagnetische Strahlung die im strahlungsemittierenden Bereich 8 erzeugt wird tritt beispielsweise durch die dem strahlungsemittierenden Bereich 8 nachgeordnete Linse 10 aus der Dünnfilmschicht 2 aus. Besonders bevorzugt sind die Linsen 10 durch wenigstens einen Ätzprozess in der Oberfläche 9 der Dünnfilmschicht 2 gebildet.

Weiter ist auf der Oberfläche 9 ein Bond-Pad 11 aufgebracht, das beispielsweise aus einem elektrisch leitenden Material besteht und zum elektrischen Kontaktieren des Dünnfilmchips dient. Bevorzugt ist das Bond-Pad 11 so aufgebracht, dass die strahlungsemittierenden Bereiche 8 nicht vom Bond-Pad 11 verdeckt werden.

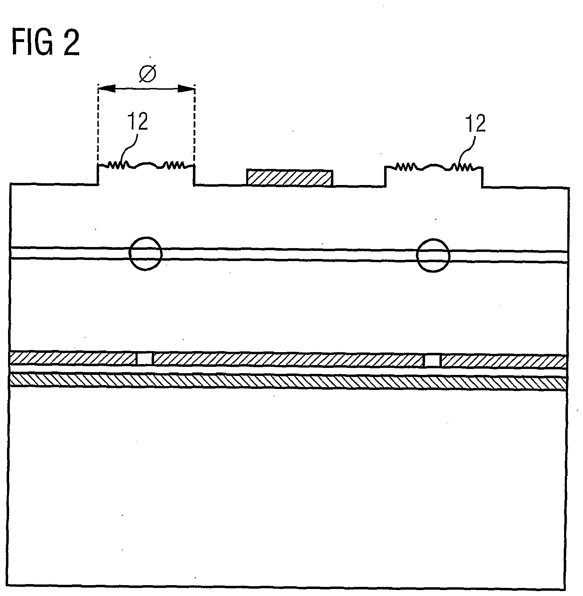

Figur 2 (nicht erfindungsgemäßes Ausführungsbeispiel) zeigt im Unterschied zur Figur 1, dass die Linse auch durch eine Fresnel-Linse 12 gegeben sein kann. Bevorzugt ist die Fresnel-Linse 12 durch wenigstens einen Ätzprozess in die Oberfläche 9 der Dünnfilmschicht 2 strukturiert.

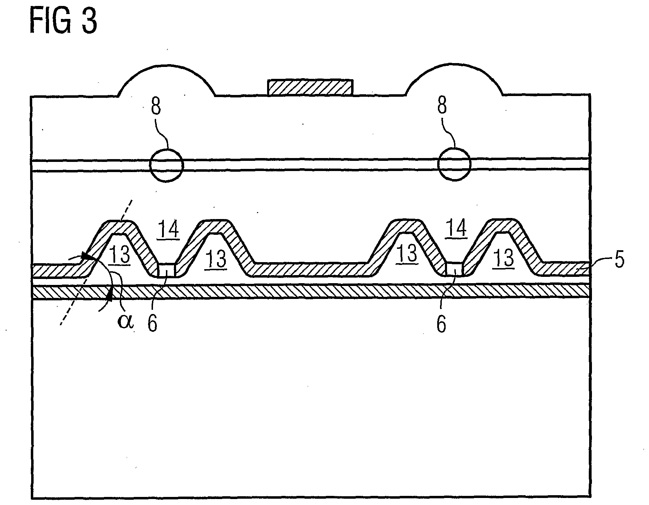

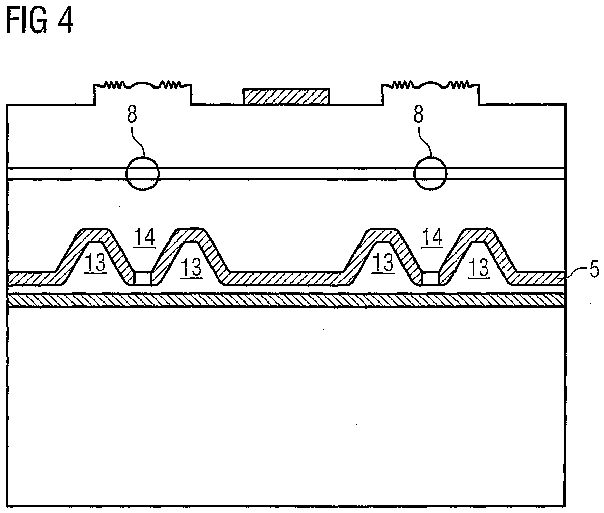

Figuren 3 und 4 zeigen im Unterschied zu den Figuren 1 und 2 Ausführungsbeispiele des oberflächenemittierenden Dünnfilmchips, bei denen in die Grenzfläche zwischen Dünnfilmschicht 2 und Träger 1 Vertiefungen 13 eingebracht sind. Dabei ist jeder Strahlungseinkoppelbereich 6 bevorzugt von wenigstens einer Vertiefung 13 umgeben. Beispielsweise kann die Vertiefung 13 ringförmig um den Stromeinkoppelbereich 6 angeordnet sein. Die Vertiefungen 13 können sich beispielsweise bis zur aktiven Zone 7 erstrecken. Bevorzugt weisen die Vertiefungen 13 eben verlaufende Innenwände auf, die mit einer Ebene parallel zur Grenzfläche von Träger 1 und Dünnfilmschicht 2 einen Winkel α einschließen.

Die Innenwände der Vertiefung 13 sind bevorzugt mit der dielektrischen Schicht 5 und der reflektierenden Schicht 4 bedeckt. Sie sind daher für die in den strahlungsemittierenden Bereichen 8 erzeugte elektromagnetische Strahlung zumindest teilweise reflektierend.

Durch die Vertiefungen 13 werden Mesa-Strukturen 14 definiert, an deren Fußpunkt jeweils ein Stromeinkoppelbereich 6 angeordnet ist.

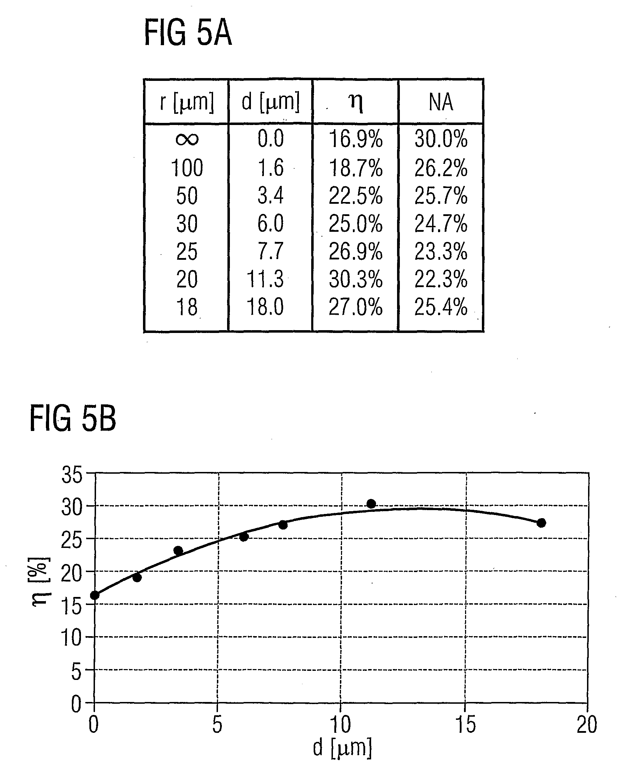

Figur 5a zeigt eine Tabelle mit Berechnungsergebnissen. Die Berechnungen wurden beispielhaft durchgeführt für eine aktive Zone 7 eines Dünnfilmchips im Phosphid-Verbindungshalbleitermaterialsystem. Die aktive Zone 7 weist dabei eine Dicke von 0,6 *µ*m mit einer Absorption von 0,9/*µ*m auf und besitzt einen internen Wirkungsgrad von 0,4. Die laterale Ausdehnung des Stromeinkoppelbereichs beträgt beispielsweise 26 *µ*m. Der Abstand h zwischen aktiver Zone 7 und Fußpunkt 10a der Linse ist in diesen Berechnungen auf 4 *µ*m gesetzt. Die Berechnungen sind für ein Ausführungsbeispiel mit einer Vertiefung 13 durchgeführt die 3 *µ*m tief ist. Die Innenwände der Vertiefung 13 schließen dabei einen Winkel *α* von 30 Grad mit der Ebene der Grenzfläche von Dünnfilmschicht 2 und Träger 1 ein. Die Berechnungen sind durchgeführt für eine sphärische Volumenlinse 10, wobei der Durchmesser der Linse am Fußpunkt auf Φ gleich 36 *µ*m festgesetzt ist. Im Folgenden wird der Radius r und damit die Dicke d der Linse 10 variiert. Abhängig vom Radius r der Linse 10 sind der Auskoppelwirkungsgrad *η*, das heißt der Anteil der elektromagnetischen Strahlung der den Dünnfilmschicht verlässt, sowie der Prozentteil der Strahlung NA der in die numerische Apertur 0,5 emittiert wird berechnet.

Wie Figur 5b zeigt, ergibt sich in Abhängigkeit von der Dicke d der Linse 10 ein maximaler Auskoppelwirkungsgrad *η* bei d ungefähr 11 *µ*m. Der zugehörige Linsenradius r beträgt circa 20 *µ*m. Das heißt bei festem Abstand h zwischen Fußpunkt 10a der Linse 10 und aktiver Zone 7 lässt sich durch Variation der Krümmung r der Linse 10 eine optimale Auskoppeleffizienz *η* einstellen, die verglichen mit dem Auskoppelwirkungsgrad *η* bei flacher Oberfläche der Dünnfilmschicht (*r*→∞) ungefähr um das 1,8-fache erhöht ist.

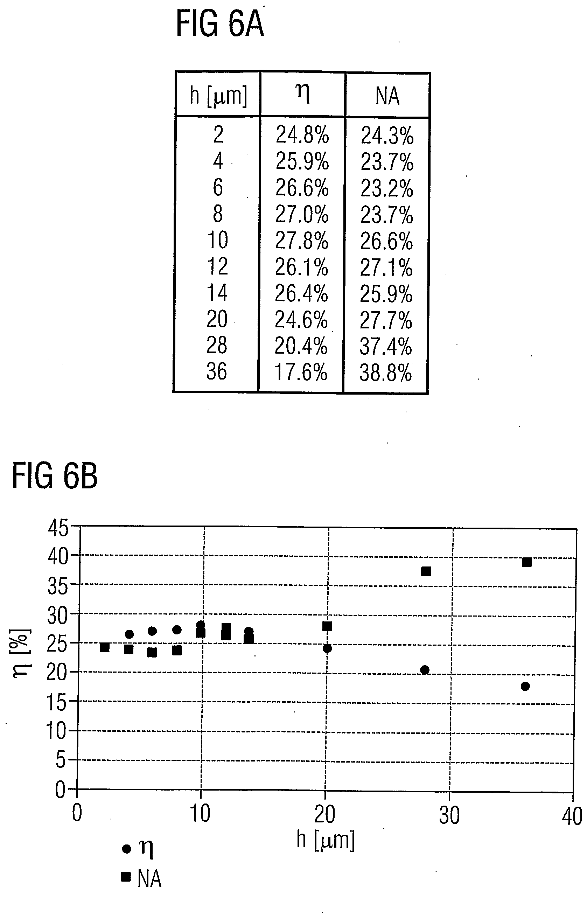

Figur 6a zeigt bei ansonsten unveränderten Parametern Berechnungen mit einem Radius r der sphärischen Linse 10 von circa 30 *µ*m, unter Variation des Abstandes h zwischen strahlungsemittierenden Bereich 8 und Fußpunkt 10a der Linse 10.

Wie Figur 6b beispielsweise zeigt, findet bei größeren Werten von h ab circa 25 *µ*m eine verstärkte Emission in die numerische Apertur 0,5 statt. Das heißt, die Abstrahlcharakteristik des Dünnfilmchips ist für diese Werte von h gerichtet und es findet eine Bündelung der Emission in eine Richtung die senkrecht auf der Oberfläche 9 der Dünnfilmschicht 2 steht statt. Durch Variation von h lässt sich also die Abstrahlcharakteristik des Dünnfilmchips definiert einstellen.

Die Erfindung ist nicht durch die Beschreibung anhand der Ausführungsbeispiele beschränkt.

Diese Patentanmeldung beansprucht die Priorität der deutschen Patentanmeldung 102004046792.7-33.

## Patentansprüche

1. Optoelektronischer Dünnfilmchip, aufweisend
- wenigstens einen strahlungsemittierenden Bereich (8) in einer aktiven Zone (7) einer Dünnfilmschicht (2), und
- eine dem strahlungsemittierenden Bereich (8) nachgeordnete Linse (10, 12), die durch zumindest einen Teilbereich der Dünnfilmschicht (2) gebildet ist, wobei die laterale Ausdehnung (Φ) der Linse (10, 12) größer ist als die laterale Ausdehnung des strahlungsemittierenden Bereichs (δ),
- ein Abstand zwischen dem strahlungsemittierendem Bereich (8) und einem Fußpunkt (10a) der Linse (10, 12) zwischen 1 und 25 µm beträgt, **dadurch gekennzeichnet, dass**
- der Dünnfilmchip einen Träger (1) aufweist, der auf einer der Linse (10, 12) gegenüberliegenden Seite der Dünnfilmschicht (2) aufgebracht ist,
- zumindest ein Stromeinkoppelbereich (6) vorhanden ist, der zwischen Träger (1) und Dünnfilmschicht (2) angeordnet ist, wobei die laterale Ausdehnung der Linse (Φ) größer ist als die laterale Ausdehnung des Stromeinkoppelbereichs (δ),
- eine Vertiefung (13) in einer Grenzfläche der Dünnfilmschicht (2), die dem Träger (1) zugewandt ist, eingebracht ist, wobei die Vertiefung (13) den Stromeinkoppelbereich (6) zumindest teilweise umgibt und wobei die Vertiefung (13) die aktive Zone (7) nicht durchtrennt.

2. Optoelektronischer Dünnfilmchip nach dem vorhergehenden Anspruch,
mit mehreren strahlungsemittierenden Bereichen (8), bei dem jedem strahlungsemittierenden Bereich (8) genau eine Linse (10, 12) nachgeordnet ist.

3. Optoelektronischer Dünnfilmchip nach zumindest einem der vorhergehenden Ansprüche,
bei dem die laterale Ausdehnung (Φ) der Linse (10, 12) zwischen 30 und 100 µm beträgt.

4. Optoelektronischer Dünnfilmchip nach zumindest einem der vorhergehenden Ansprüche,
bei dem die laterale Ausdehnung (δ) des Stromeinkoppelbereichs (6) zwischen 1 und 80 µm beträgt.

5. Optoelektronischer Dünnfilmchip nach zumindest einem der vorhergehenden Ansprüche,
bei dem der Abstand zwischen strahlungsemittierendem Bereich (8) und einem Fußpunkt (10a) der Linse (10, 12) zwischen 1 und 10 µm beträgt.

6. Optoelektronischer Dünnfilmchip nach dem vorhergehenden Anspruch,
bei dem die Vertiefung (13) zwischen 1 und 20 µm tief ist.

7. Optoelektronischer Dünnfilmchip nach einem der vorhergehenden Ansprüche,
bei dem sich die Vertiefung (13) in Richtung der dem Träger (1) abgewandten Oberfläche der Dünnfilmschicht (2) verjüngt und die Innenwände der Vertiefung (13) mit dem Träger (1) einen Winkel (α) zwischen 10 und 90° einschließen.

8. Optoelektronischer Dünnfilmchip nach einem der vorhergehenden Ansprüche,
bei dem zwischen dem Träger (1) und der Dünnfilmschicht (2) eine Spiegelschicht (4) angeordnet ist, wobei die Spiegelschicht (4) ein metallhaltiger Spiegel oder ein Bragg-Spiegel ist.

9. Optoelektronischer Dünnfilmchip nach einem der vorhergehenden Ansprüche,
bei dem der Träger (1) durch eine flexible, elektrisch leitende Folie gebildet ist, wobei eine Dicke der Folie kleiner oder gleich 100 µm ist.

10. Optoelektronischer Dünnfilmchip nach einem der vorhergehenden Ansprüche,
der wenigstens 80 strahlungsemittierende Bereiche (8) und wenigstens 80 den strahlungsemitterenden Bereichen (8) nachgeordnete Linsen (10, 12) aufweist.

11. Verfahren zur Herstellung eines Dünnfilmchips nach zumindest einem der vorhergehenden Ansprüche,
wobei wenigstens eine Linse (10, 12) auf einer einem Träger (1) abgewandten Oberfläche (9) einer epitaktisch auf einem Aufwachssubstrat abgeschiedenen Dünnfilmschicht (2) hergestellt wird, wobei das gesamte Aufwachssubstrat von der Dünnfilmschicht (2) entfernt ist.

12. Verfahren zur Herstellung eines Dünnfilmchips nach dem vorhergehenden Anspruch,
wobei die Linse (10, 12) mittels eines Ätzprozesses hergestellt wird.

## Claims

1. Optoelectronic thin-film chip comprising
- at least one radiation-emitting region (8) in an active zone (7) of a thin-film layer (2), and
- a lens (10, 12) which is arranged downstream of the radiation-emitting region (8) and which is formed by at least a partial region of the thin-film layer (2), wherein the lateral extent (Φ) of the lens (10, 12) is greater than the lateral extent of the radiation-emitting region (δ),
- a distance between the radiation-emitting region (8) and a base point (10a) of the lens (10, 12) is between 1 and 25 µm,
**characterized in that**
- the thin-film chip comprises a carrier (1) applied to a side of the thin-film layer (2) opposite the lens (10, 12),
- at least one current injection region (6) is present, which is arranged between the carrier (1) and the thin-film layer (2), the lateral extent of the lens (Φ) being greater than the lateral extent of the current injection region (δ),
- a depression (13) is introduced in an interface of the thin-film layer (2) which faces the carrier (1), wherein the depression (13) at least partially surrounds the current injection region (6) and wherein the depression (13) does not cut through the active zone (7).

2. Optoelectronic thin-film chip according to the preceding claim,
having a plurality of radiation-emitting regions (8), in which exactly one lens (10, 12) is arranged downstream of each radiation-emitting region (8).

3. Optoelectronic thin-film chip according to at least one of the preceding claims,
in which the lateral extent (Φ) of the lens (10, 12) is between 30 and 100 µm.

4. Optoelectronic thin-film chip according to at least one of the preceding claims,
in which the lateral extent (δ) of the current injection region (6) is between 1 and 80 µm.

5. Optoelectronic thin-film chip according to at least one of the preceding claims,
in which the distance between the radiation-emitting region (8) and a base point (10a) of the lens (10, 12) is between 1 and 10 µm.

6. Optoelectronic thin-film chip according to the preceding claim,
in which the depression (13) is between 1 and 20 µm deep.

7. Optoelectronic thin-film chip according to one of the preceding claims,
in which the depression (13) tapers in the direction of the surface of the thin-film layer (2) facing away from the carrier (1) and the inner walls of the depression (13) enclose an angle (α) of between 10 and 90° with the carrier (1) .

8. Optoelectronic thin-film chip according to one of the preceding claims,
in which a mirror layer (4) is arranged between the carrier (1) and the thin-film layer (2), the mirror layer (4) being a metal-containing mirror or a Bragg mirror.

9. Optoelectronic thin-film chip according to one of the preceding claims,
in which the carrier (1) is formed by a flexible, electrically conductive film, wherein a thickness of the film is less than or equal to 100 µm.

10. Optoelectronic thin-film chip according to any of the preceding claims,
which has at least 80 radiation-emitting regions (8) and at least 80 lenses (10, 12) arranged downstream of the radiation-emitting regions (8).

11. Method of manufacturing a thin-film chip according to at least one of the preceding claims,
wherein at least one lens (10, 12) is produced on a surface (9) of a thin-film layer (2) facing away from a carrier (1), the thin-film layer (2) being epitaxially deposited on a growth substrate, wherein the entire growth substrate is removed from the thin-film layer (2).

12. Method of manufacturing a thin-film chip according to the preceding claim,
wherein the lens (10, 12) is manufactured by means of an etching process.

## Revendications

1. Puce optoélectronique à film fin, présentant
- au moins un secteur émetteur de rayonnement (8) dans une zone active (7) d'une couche de film fin (2), et
- une lentille (10, 12) disposée en aval du secteur émetteur de rayonnement (8), qui est constituée par au moins un secteur partiel de la couche de film fin (2), l'extension latérale (Φ) de la lentille (10, 12) étant plus grande que l'extension latérale du secteur émetteur de rayonnement (8),
- un espace entre le secteur émetteur de rayonnement (8) et un pied (10a) de la lentille (10, 12) qui s'élève à entre 1 et 25 µm,
**caractérisé en ce que**
- la puce à film fin (1) présente un support (1), qui est appliqué sur un côté de la couche de film fin (2) opposé à la lentille (10, 12),
- au moins un secteur d'injection de courant (6) est présent, qui est disposé entre le support (1) et la couche de film fin (2), sachant que l'extension latérale de la lentille (Φ) est plus grande que l'extension latérale du secteur d'injection de courant (δ),
- un renfoncement (13) est appliqué dans une surface limite de la couche de film fin (2), qui est tournée vers le support (1), sachant que le renfoncement (13) entoure au moins partiellement le secteur d'injection de courant (6) et sachant que le renfoncement (13) ne sectionne pas la zone active (7).

2. Puce optoélectronique à film fin selon la revendication précédente
avec plusieurs secteurs émetteurs de rayonnement (8), pour laquelle exactement une lentille (10, 12) est placée en aval de chaque secteur émetteur de rayonnement (8).

3. Puce optoélectronique à film fin selon au moins une quelconque des revendications précédentes,
pour laquelle l'extension latérale (Φ) de la lentille (10, 12) s'élève à entre 30 et 100 µm.

4. Puce optoélectronique à film fin selon au moins une quelconque des revendications précédentes,
pour laquelle l'extension latérale (δ) du secteur d'injection de courant (6) s'élève à entre 1 et 80 µm.

5. Puce optoélectronique à film fin selon au moins une quelconque des revendications précédentes,
pour laquelle l'espace entre le secteur émetteur de rayonnement (8) et un pied (10a) de la lentille (10, 12) s'élève à entre 1 et 10 µm.

6. Puce optoélectronique à film fin selon la revendication précédente
pour laquelle le renfoncement (13) est à entre 1 et 20 µm de profondeur.

7. Puce optoélectronique à film fin selon une quelconque des revendications précédentes,
pour laquelle le renfoncement (13) diminue dans la direction de la surface détournée du support (1) de la couche de film fin (2) et en ce que les parois intérieures du renfoncement (13) comportent avec le support (1) un angle (α) entre 10 et 90°.

8. Puce optoélectronique à film fin selon une quelconque des revendications précédentes,
pour laquelle entre le support (1) et la couche de film fin (2), une couche miroir (4) est disposée, sachant que la couche miroir (4) est un miroir métallique ou un miroir de Bragg.

9. Puce optoélectronique à film fin selon une quelconque des revendications précédentes,
pour laquelle le support (1) est constitué par un film flexible conducteur électriquement, sachant qu'une épaisseur de la feuille est inférieure ou égale à 100 µm.

10. Puce optoélectronique à film fin selon une quelconque des revendications précédentes,
qui présente au moins 80 secteurs émetteurs de rayonnement (8) et au moins 80 lentilles (10, 12) disposées en aval des secteurs émetteurs de rayonnement (8).

11. Procédé en vue de la fabrication d'une puce optoélectronique à film fin selon au moins une quelconque des revendications précédentes,
sachant qu'au moins une lentille (10, 12) est fabriquée sur une surface (9) détournée du support (1) d'une couche de film fin (2) déposée épitaxialement sur un substrat d'épitaxie, sachant que l'ensemble du substrat d'épitaxie est ôté de la couche de film fin (2).

12. Procédé en vue de la fabrication d'une puce optoélectronique à film fin selon la revendication précédente,
sachant que la lentille (10, 12) est fabriquée au moyen d'un procédé de gravure.
